Europäisches Patentamt

(19) European Patent Office    (11) Publication number: **0 180 013**
Office européen des brevets                                **B1**

(12)                    **EUROPEAN PATENT SPECIFICATION**

(45) Date of publication of the patent specification:    (51) Int. Cl.⁴: **G01R 1/073**, G01R 31/28
02.05.90

(21) Application number: **85111439.7**

(22) Date of filing: **10.09.85**

(54) **Test probe system.**

(30) Priority: **21.09.84 US 652981**

(43) Date of publication of application:
**07.05.86 Bulletin 86/19**

(45) Publication of the grant of the patent:
**02.05.90 Bulletin 90/18**

(84) Designated Contracting States:
**DE FR GB**

(56) References cited:
**EP-A- 0 050 913**
**FR-A- 2 211 651**
**US-A- 3 382 437**

(73) Proprietor: **International Business Machines Corporation, Old Orchard Road, Armonk, N.Y. 10504(US)**

(72) Inventor: **Cavaliere, Joseph Richard, Rural Rt. 7, Box 74, Hopewell Junction New York 12533(US)**
Inventor: **Lafave, Lawrence Edward, 4 Camill Drive, Poughkeepsie New York 12603(US)**
Inventor: **Feinberg, Irving, 13 Meadow View Drive, Poughkeepsie New York 12603(US)**
Inventor: **Kraus, Charles John, 38 Carmen Drive, Poughkeepsie New York 12603(US)**
Inventor: **Mack, Alfred, 79 Lauer Road, R.d. No. 2, Poughkeepsie New York 12603(US)**
Inventor: **Valentine, Edward Hubert, 3 Top-O-Hill Road, Wappingers Falls New York 12590(US)**

(74) Representative: **Klocke, Peter, Dipl.-Ing., IBM Deutschland GmbH Patentwesen und Urheberrecht Schönaicher Strasse 220, D-7030 Böblingen(DE)**

## Description

The present invention relates generally to a high speed test apparatus for testing high density integrated circuits and, more particularly, to a test lead space transformer and rigid test probe structure utilized to contact the native power, ground and signal pads (or terminals) of an integrated circuit package in its otherwise unmounted state and in wafer form.

In the genesis of an integrated circuit, the earliest point in time that full thermal cycling and electrical functional testing can be performed occurs when the circuit is contained in a chip on the wafer native package. Testing at this point is highly desirable for many practical reasons. Perhaps most important is that is allows circuit evaluation independent of the influence of any external or non-native components that may otherwise compromise the observable electrical characteristics of the native circuit. Further, the physical isolation of the circuit allows it to be operated in a controlled environment that can be varied to approximate any of its intended operating environments.

Conventionally, the testing of such native integrated circuits is accomplished by contacting the native pads of the circuit with conductive probes attached to an appropriate test system. The probes are utilized to provide the requisite power and test signals needed to drive the circuit in its intended modes of operation and return the output signals generated, in turn, by the circuit. Full functional testing of the native circuit can thus be performed.

However, there are a number of problems that are inherently encountered in performing native circuit testing. Foremost, they include the physical difficulty of nondestructively contacting the pad of the circuit test, yet obtaining a good electrical connection. Also, the performance and physical connection of the test apparatus and probes must not influence, degrade or otherwise affect the electrical performance of the circuit under test. Other problems that must be considered include ensuring the controlled thermal operation of the circuit throughout its electrical evaluation and the prevention of any damage that may subsequently affect the operation of the circuit. All of these problems are exacerbated as the operating speeds, degree of circuit integration and number of native pads that must be supported increase while their physical dimensions, particularly the spacing between adjacent native pads, decrease.

A test probe system according to the preamble of claim 1 discloses FR-A-2 211 651. This test probe system is not suitable to transmit signals at high frequency.

The invention as claimed is intended to provide a remedy. It solves the problem of how to design a test probe system capable of non-destructive interconnecting a high speed tester with the native conductive pad array of a high speed, high density integrated circuit device and suitable to transmit signals at high frequency.

This is accomplished in the present invention by a system according to claim 1 comprising a multilayer space transformer including one or more power planes, ground planes, and signal wiring planes, a rigid probe structure including a plurality of parallel probes spatially arrayed to substantially perpendicularly match the pad array of the integrated circuit, the probes including at least a power, a ground and a signal probe associated with their respective power, ground, and signal wiring plane of the space transformer, and plurality of conductors interconnecting the space transformer with the tester, at least a respective one of the conductors being associated with each of the power, ground, and signal wiring planes, the space transformer including means for conductively interconnecting the probes of the probe structure with the tester conductors, wherein all conducting wires interconnecting signal probes of said probe structure with signal carrying terminals of said space transformer lie within said wiring plane uniformly spaced apart from a ground plane by a layer of insulating material so as to provide a transmission line having a predetermined impedance in order to achieve an improved high frequency transmission of signals between the integrated circuit device and the tester.

Thus, an advantage of the present invention is that it provides a highly reliable, readily producible, nondestructive means for contacting the native pads of a high speed integrated circuit to frequencies above 500 MHz with transient times of less than 200ps.

Another advantage of the present invention is that it permits the impedance of the signal lines of the tester and signal probes to be optimally matched and maintained with regard to the pads of the circuit under test and substantially reduce signal reflections at the probe/pad interface.

A further advantage of the present invention is that it permits the impedance of the power probe to be separately optimized from that of the signal probes and thereby substantially reduce current noise introduced into the circuit under test. The present invention also provides for the coaxial shielding of the signal probes along essentially their entire length resulting in the essential elimination of cross-talk between the probes and inductive pickup from other external sources. In addition, with the present invention the probe structure is rigid and directly scalable to a minimum probe-to-probe dimension determined by the limit of initial fabrication capabilities and not by operational considerations. The present invention utilizes a space transformer design that has a low inductive characteristic mesh power, ground and signal plane design that further allows for the direct attachment of low inductive concention decoupling capacitors to minimize the introduction of noise. Another advantage of the present invention is that is provides for excellent electrical contact between the probes and the native pads, and a contact with minimum probe pressure and without any significant damage to the pads.

The invention is described in detail below with reference to the drawings of which:

Fig. 1 is a sectional view of the preferred multilayer ceramic space transformer and rigid test probe embodiment of the present invention generally indicating its preferred mode of operation;

Fig. 2 is a detailed sectional view of a portion of the multilayer ceramic space transformer and rigid test probe assembled as a unitary structure in accordance with the present invention;

Fig. 3 is a detailed sectional view of a portion of the preferred rigid test probe structure of the present invention; and

Fig. 4 is a somewhat stylized isometric view of a test station incorporating the invention of Figs. 1 - 3, a portion of a housing of the station being cut away to show interior components.

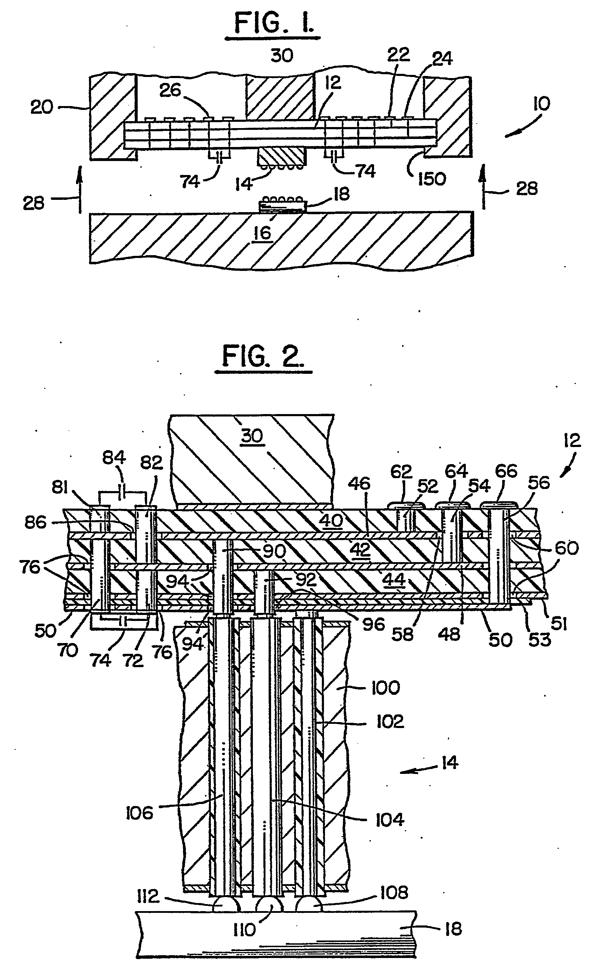

Referring to the drawings and in particular to Fig. 1, a test station 10 utilizing the space transformer and rigid test probe structure of the present invention is shown. The test station 10 provides a space transformer 12 with an attached rigid probe structure 14 which may also be referred to as an interposer and is in close proximity and movable with respect to an integrated circuit 18. The probe structure or interposer 14 provides clearance between the space transformer 12, including any components such as capacitors 74 which may be mounted thereon, and the integrated circuit 18. As is readily apparent to persons skilled in the art, the circuit 18 is in its native package, at the wafer stage or mounted in a suitable holder, here simply represented by the flat 16, so as to present and make accessible the array of native pads of the circuit in a plane preferably parallel to the flat 16.

The rigid probe structure 14, which is generally attached to the space transformer 12 at the bottom surface center thereof by bonding with solder ball preforms to the corresponding connections of the space transformer, preferably contains a number of probe wires extending through the body of the probe structure 14 generally parallel to one another. The probe wires are preferably arrayed so as to orthogonally match the corresponding array, or footprint, of native contact pads of the integrated circuit 18. Correspondingly, the number of probe wires is preferably equal to or less than the number of native pads as necessary to provide power and driving pads as necessary to provide power and driving test signals therefrom. The probe structure or interposer 14 may be removed from the transformer 12 for servicing or repair of the interposer 14, if required.

The overall configuration of the space transformer 12 has the form of a disk (only one side view being shown), preferably square, though a circular or other shape may be employed. The transformer 12 is held by a square housing 20 such that the resulting structure is held rigid with respect to the movable flat 16. Functionally, the space transformer 12 acts as an interface between the test power and signal leads of conventionally sized electronic test devices and the wires of the rigid probe structure 14. The space transformer 12 is utilized to generally reduce the physical displacement of the test leads and conductively route them to positionally match and ultimately interconnect with their respective wires of the rigid probe structure 14. Preferably, the space transformer 12 is a multilayer structure providing for the separate routing of the power, ground and test signals at different layer surfaces of the structure 12. Vias and short conductive busses 22, 24, 26 passing therethrough are preferably provided to allow the various power, ground and signal conductors to be accessed from the top surface of the space transformer 12.

In operation, the housing is utilized to appropriately align the rigid probe structure 14 with the integrated circuit 18 so as to superimpose the probe wires over their corresponding contact pads. The space transformer 12 is held stationary and the flat 16 then driven toward the transformer 12 as indicated by the arrows 28, until the tips of the probe wires encounter the pads of the integrated circuit with sufficient pressure to ensure proper electrical contact there between. A stiffener 30, abutting the top surface of the space transformer 12 opposite the rigid probe structure 14, may be connected to a top (not shown in Fig. 1) of the housing 20 to prevent the space transformer 12 from flexing as pressure is applied thereto by the flat 16.

After testing, the flat 16 is backed off and the integrated circuit 18 can be removed undamaged. The foregoing structure of the invention is used to test chips in wafer form before dicing (cutting the wafer into smaller units).

Fig. 2 provides a detailed view of the preferred embodiment of the space transformer 12 and an attached portion of a rigid probe structure 14 constructed in accordance with the present invention. The space transformer 12 is preferably a multilayer ceramic structure fabricated utilizing conventional multilayer ceramic laminate technology. The structure so formed preferably includes three or more ceramic layers 40, 42, 44 separated by two or more highly conductive material layers 46, 48 constructed preferably of a metal or metal alloy having a coefficient of expansion similar to that of the specific ceramic used. The first conductive layer 46 is preferably used as a power plane for reasons that will be discussed in greater detail below.

A via provided in the layer 40 allows a conductive bus 52, preferably of a conductive metal such as molybdenum, to extend between the power plane 46 and an electrode 62. The electrode 62 is disposed on the external surface of the ceramic layer 40, which external surface serves as the top surface of the space transformer 12. Similarly, a conductive bus 54 extends between the ground plane 48 and a surface electrode 64 through vias in the two interposed ceramic layers 40, 42 as well as an opening 58 in the power plane 46 needed to prevent shorting of the plane 46 to the bus 54. It is to be understood that many electrodes 62, 64 and 66 and their corresponding busses are present in the transformer 12, only one each of the electrodes being shown for clarity.

A desired plurality of signal busses 56 are provided to conduct signals from electrodes 66, present on the top surface of the space transformer 12, to conductors 50 below the ceramic layer 44. The busses 56 extend through respective vias in the ceramic layers 40, 42, 44 and openings 60 in the power and ground planes. Conventional thin film deposition techniques are used to provide a high frequency ( >500MHz ) AC ground reference layer 51 overlying substantially all of the bottom surface of the ceramic layer 44 and insulated from the conductors 50 by an insulator layer 53. Thin film conductors 50 conductively connected to respective signal busses 56 are provided adjacent to the reference layer 51 and patterned as necessary to spatially match the signal probe wire array to be described in greater detail below.

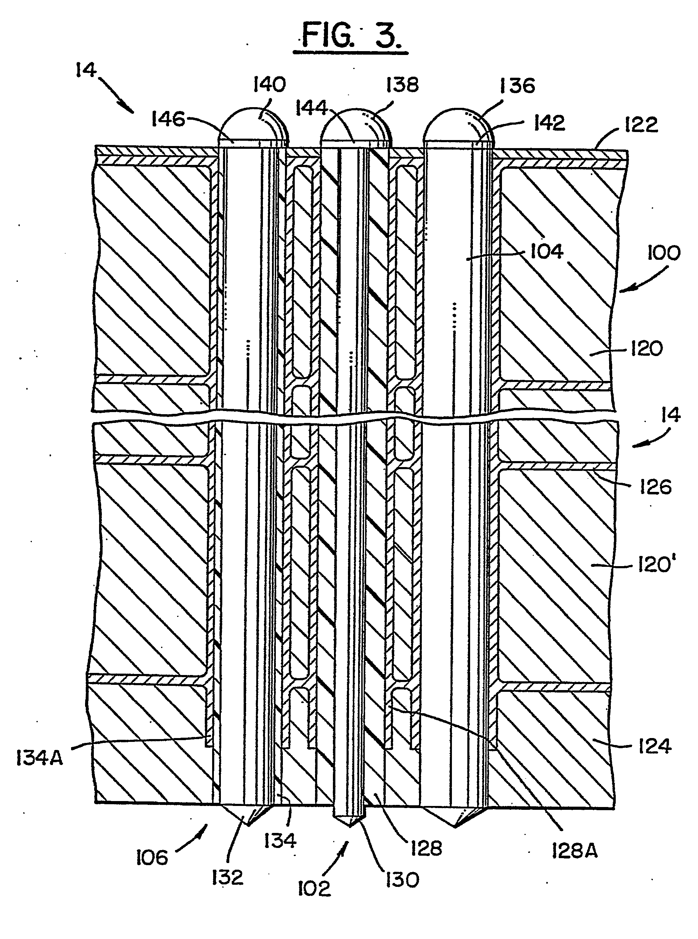

The preferred rigid test probe structure 14 is described in detail with respect to Fig. 3. However, as shown in Fig. 2, the rigid probe 14 generally includes a structural body 100 of a conductive metal. Signal probe 102, ground probe 104, and power probe 106 extend through the body 100 sufficiently for the probe points to contact respectively the signal pad 108, ground pad 110, and power pad 112 (these being native pads, typically C-4 solder bumps) of the integrated circuit 18.

The opposite ends of the probes 102, 104, 106 are conductively connected to their respective planes 50, 48, 46 of the space transformer 12. That is, the power probe 106 conductively abuts a bus 90 extending from the power plane 46 to the bottom surface of the space transformer 12 through vias in the lower two ceramic layers 42, 44 and openings 94 in the ground reference layer 51 and plane of film conductor 50. Similarly, a bus 92 conductively extends from the ground plane 48 to the bottom surface of the space transformer 12 through a via in the bottom ceramic layer 44 to reference layer 51 and through an opening 96 in layer 50 to connect to the ground probe 104. The signal probes 102 conductively connect directly to the wiring respective thin film conductors 50. All probes 102, 104 and 106 are bonded to their corresponding connection of the space transformer by solder.

In viewing the structure of Fig. 2, it is to be understood that only a small portion of the tests station 10 is shown. The probe structure 14 has numerous probes in addition to the three probes 102, 104 and 106 shown in the Figure. The structure 14 has a square or rectangular form wherein the height may be much smaller than the width and length, and the probes are arranged in a parallel array within the probe structure 14. There is a corresponding number of conductors 50, each being insulated from the other, and the conductors 50 connect between respective ones of the probes of the structure 14 and the busses of the space transformer 12.

The preferred structure of the space transformer 12 is essentially completed by the provision of low inductive, high-frequency decoupling capacitors 74, 84 extending between the power 46 and ground 48 planes. The capacitors 74, 84 are preferably of a thin film construction and provided as desired on the top and bottom external surfaces of the space transformer 12. Connection is made to the power 46 and ground 48 planes by power busses 70, 81 and ground busses 72, 82 extending through vias in the ceramic layers 40, 42, 44 and openings 76, 86 in the power and ground planes as needed.

The short length of connection between the capacitors 74, 84 and the power plane 46 and ground plane 48, and the short connection to the probe structure 14 results in a minimum connection inductance. Naturally, the high-frequency behavior of the capacitors 74, 84 depend on the dimensions of the capacitor electrodes and dielectric parameters of the capacitor insulator material. The use of thin film capacitors solder bonded essentially on the surfaces of the space transformer 12 and connected by integral busses allows the capacitors to be placed at any convenient point and contributes to the realization of a unitary, easily manipulated structure.

It should be noted that the structure of the space transformer 12 constructed in accordance with the present invention may be such that the planes 46, 48, 50 etc. are solid (e.g. thin film) or designed with openings in accordance with a pre-arranged pattern, such as a mesh. The ground plane 48, and power plane 46 are used to distribute power. With respect to the power plane 46 and ground plane 48, the provision of the low connection inductance decoupling capacitors stabilizes the high-frequency power voltage potential to significantly reduce the generation of current noise (dI/dt).

With respect to the film conductors 50, the provision of the reference or ground plane 51 and the insulator layer 53 which, by the proper selection of the dimensions of the thin film conductors 50 according to standard transmission line theory, permits the characteristic impedance of the conductors 50 to be maintained at an optimal value, preferably fifty ohms. Thus, the impedance of the signal conductors 50 can be independently established at a value much higher than that of the power and ground planes (generally less than 1 ohm, and preferably less than 0.1 to 0.5 ohms).

Referring to Fig. 3 now, the rigid test probe structure 14 is preferably constructed as an initially separate composite component. As shown, the body 100 is formed of a succession of body layers 120...120', fabricated preferably of a conductive metal such as molybdenum to provide vias for the subsequent insertion of probe wires therethrough. The orientation and dimensions of the spatial array of vias is, of course, dependent on those of the native pads 108, 110, 112 (shown in Fig. 2) of the integrated circuit 18 that is the desired test object.

The ground probe 104 is preferably of a small diameter, highly conductive metal alloy, such as a gold alloy, that bonds easily by reflow solder techniques. Consequentially, the probe body 100 will be intimately conductively connected to the ground probe and, since it largely surrounds the entire probe wire array, conveniently acts as an electromagnetic shield and ground connection for the power and signal probes.

The signal probe 102 preferably has a center conductor 130 of the same metal alloy as the ground probe 104. The center conductor is provided with a coating 128 of a high dielectric material, such as paralene, and one or more successive layers 128A of a conductor such as chromium, copper and tin/lead to effectively form a coaxial structured probe 102. Preferably, the chromium layer is provided as the first such layer on the coating 128 to enhance the adherence of the subsequent metal layers 128A. The tin/lead layer 128A is preferably provided last and thus is available to enhance the conductive bonding of the signal probe 102 to the probe body 100.

The diameter of the center conductor 130 and the thickness of the coating 128 are selected such that the signal probe 102 has substantially the same ultimate outside diameter as the ground probe 104 and, further, a desired characteristic impedance for the transmission of test signals, again preferably fifty ohms. Naturally, the choice of conductor and insulator materials is premised on their ability to tolerate reflow solder bonding temperatures and provede sufficient structural strength to withstand the ultimately encountered probing forces.

The power probe 106 is formed of a center conductor 132 coated with a thin dielectric film 134 and successive layers 134A of either chromium or copper, or both, followed by one of lead/tin. The final diameter of the power probe 106 is preferably the same or similar to that of the ground and signal probes 102, 104. In order to minimize inductance of the power probe conductor 132, the dielectric film is used to form a very low AC impedance capacitor between the conductor 132 and the probe body 100. Naturally, the probe body 100 is preferably used, thereby, as a shield as well as a convenient ground potential contact.

The capacitance value realized by the power probe dielectric film should be chosen in view of the nascent impedance of the material of the conductor 132, as is within the abilities of one skilled in the art, to obtain a conductor probe impedance less than 0.5 ohms and preferably less than 0.1 ohms. As should be apparent, this impedance value is established substantially if not completely independent from that of the signal line impedances, thereby allowing the separate impedance optimization of each.

The dielectric film should be further chosen to have a sufficiently high dielectric constant and be provided at a sufficient film thickness to resist punch-through at the operating power probe bias potential. Preferably, the probe conductor 132 is of the same metal allow as the ground probe and is coated with a tantalum oxide or equivalent dielectric film. The metal coating layers are preferred in the aforementioned order and for the reasons given above with regard to the signal probe 102.

A further consideration in the choice of the metal or alloy material for the power conductor 132, signal probe conductor 130 and ground conductor 104 is that the material should have a hardness preferably greater than that of the native pads 108, 110, 112 (Fig. 2) of the integrated circuit 18. The reason for this will become apparent by the ensuing description of the present invention.

The rigid test probe structure 14 is assembled by boring holes in each of the layers 120...120' at the locations of the various probes, then coating the body layers 120...120' with lead/tin reflow solder, appropriately stacking the body layers 120...120' to align the holes therin, inserting the signal, ground, and power probes 102, 104 and 106 respectively into respective vias of the body layers 120...120' so as to provide probe locations functionally matching the array positions of the native pads of the integrated circuit 18. The partially complete structure 14 is then heated as necessary to reflow the lead/tin alloy coatings. Naturally, a constraint on the choice of the specific lead/tin alloy used is that the necessary reflow temperature be sufficiently low to be compatible with the probe conductor metal and signal probe insulator material. The metal coatings 134A and 128A on the power probe 106 and the signal probe 102 are removed at the top and the bottom ends of the probe structure 14 to prevent shorting between conductors before application of dielectric layers 122, 124.

Top and bottom dielectric layers 122, 124, preferably of polyimide, are provided on the respective top and bottom surfaces of the probe structure 14. The initial length of each probe is sufficient to allow the wire to protrude through the dielectric layers 122, 124. At the top surface of the probe structure 14, the wires are machined essentially flush with the exposed surface of the top dielectric layer 122, while at the bottom surface the wires are planarized leaving a short length thereof extending beyond the exposed surface of the bottom dielectric layer 124. This is achieved by initially grinding the probe end flush with the dielectric layer 124 and then the probe ends are exposed by chemical or reactive ion etching.

The extent to which the probe wires desirably extend beyond the bottom dielectric layer 124 is dependent on a number of factors. Naturally, the free length of the wires must be greater than any tolerance variation incurred in the planarization of the wire tips to ensure that a useable probe tip remains. Conversely, the free wire length must be sufficiently short, in view of the material properties and physical dimensions of the probe conductor wire, to preclude any significant bending of the free wire as the ultimate probing force is repeatedly applied. Finally, and perhaps most significantly, the free length of the signal probe wire is essentially the only portion of the various signal conductive paths that are not effectively shielded within the space transformer 12 and rigid probe structure 14 of the present invention.

The low mutual inductances between the signal and power conductors and the provision of separately optimized power and signal conductor impedances results in a substantial reduction in the noise generation and signal line transmission aberration within the space transformer 12 and rigid probe structure 14. Consequently, the clean, low noise signal lines of the present invention allow it to effectively operate at frequencies in excess of 500 MHz without significant impact on the conduction of test signals having transient times of less than 200 picoseconds.

The probe wire ends at the top of the probe structure 14 are finished by providing bonding pads 136, 138, 140 on the respective exposed conductive surfaces of the ground, signal, and power probes 104, 102 and 106 respectively. Electrodes 142, 144, 146 may be provided as needed to enable or enhance the adherence of the bonding pads 136, 138, 140 to the wires of the probe 104, 102, 106. The provision of an electrode 144 is particularly necessary where the diameter of the signal probe conductor 130 is substantially less than the diameter of the signal probe 102. Consequently, the electrodes are preferably of an adherence enhancing metal, such as chromium/copper.

The bonding pads 136, 138, 140 are preferably of a conductive material having a hardness greater than that of the native pads 108, 110, 112 of the integrated circuit 18 so as be capable of withstanding repeated applications of the ultimate probing force transmitted through the probe structure 14. Further, the bonding pad material must have a melting temperature appropriately less than that of the reflow solder 126 and solder used to bond probe wires to allow bonding of the probe structure 14 to the space transformer 12 subsequent to completion of the composite probe structure 14. Accordingly, the bonding pads are preferably of a lead/tin alloy (70%:30%, by weight).

Finally, the probe wire tips at the bottom of the probe structure 14 can be finished by shaping the exposed wire tips as desired. Hemispherical, or conical points, can be formed using an electrode of preformed well- known structure in conjunction with electron discharge machining methods. The formed point are particularly desirable in that it will achieve an excellent electrical contact with the native pads of the circuit 18 by direct plastic deformation of the native pads as probe pressure is applied. Other shapes tend to require some measure of a wiping action between the probe tip and the native pads in order to obtain a clean electrical contact. The formed probe tip tends to be self cleaning and minimizes the build-up of material from the native pads of the integrated circuit.

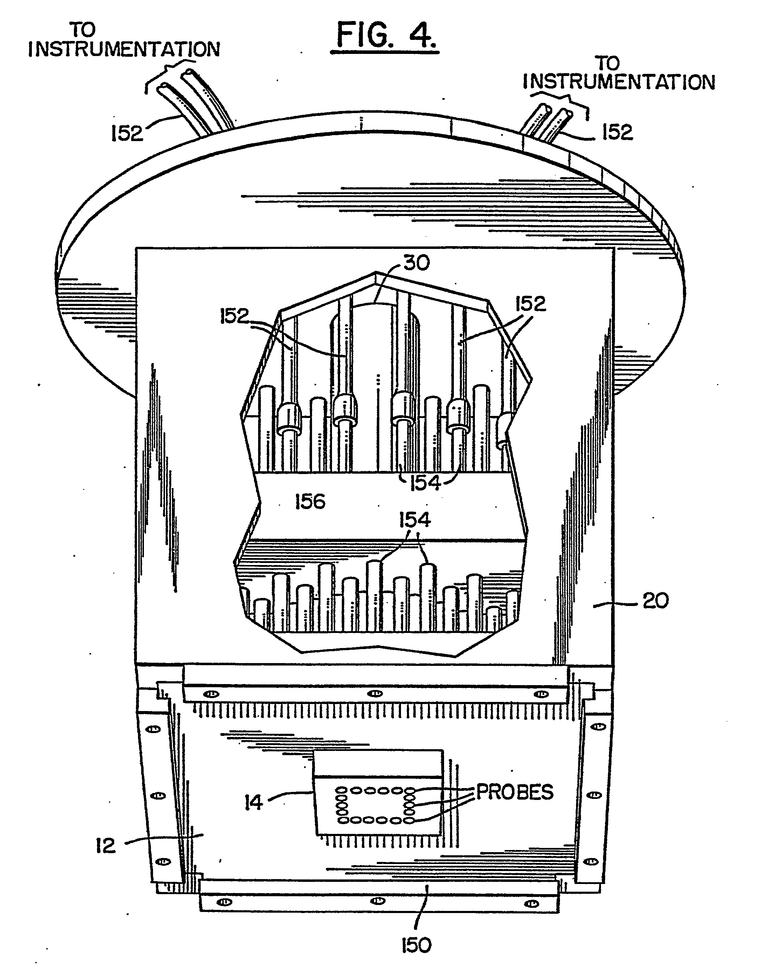

Figure 4 shows one embodiment of the test station 10 wherein the housing 20 has a square form and supports the space transformer 12 at the bottom of the housing 20 by means of a lip 150 (Figure 1) formed integrally with the housing 20. The interposer 14 is centered on the space transformer 12 and extends downwardly therefrom. The view of Figure 4 is simplified to show only those details necessary for an understanding of the locations of the basic components of the test station 10. A set of probes is shown on the bottom surface of the interposer 14 in one possible configuration of the probes for mating with the pads on an integrated circuit such as the circuit 18 of Figures 1 and 2.

Connection with terminals on the top surface of the space transformer 12, such as the terminals 62, 64 and 66 of Figure 2, is made by means of coaxial cables 152 (shown in a cut away portion of the housing 20) which are terminated in a set of probes 154 configured and arranged for contacting the terminals of the space transformer 12. The probes 154 are supported and positioned by a plate 156 which, in turn, is held by the housing 20. Only a portion of the cables 152 is shown, the remaining cables having been deleted to disclose the position of a rod 30 which extends between the space transformer 12 and a top of the housing 20, and serves to prevent deflection in the space transformer when probing force is applied to the interposer. The probes 154 may have any desired configuration. The cables 152 extend through the top of the housing 20 to provide connection of electric signals between the transformer 12 and instrumentation such as signal generators and wave form analyzers (not shown) which are used generally in the testing of integrated circuits.

## Claims

1. A test probe system for non-destructively inter connecting a high speed tester with the native conductive pad array of an integrated circuit device, with

   a) a multilayer space transformer (12) including at least a power plane (46), a ground plane (48), and a signal wiring plane (50);

   b) a rigid probe structure (14) including a plu rality of parallel probes spatially arrayed to substantially perpendicularly match the pad array of said integrated circuit (18), said probes including at least a power (106), a ground (104) and a signal probe (102) associated with its respective power, ground, and signal wiring plane of said space transformer; and

   c) means (156) for holding a plurality of con ductors (154) in contact with terminals (62, 64, 66) of said space transformer for interconnecting said space transformer with said tester, at least a respective one of said conductors being associated with each of said power (46), ground (48), and signal wiring (50) planes, said space transformer including means (152) for conductively interconnecting the probes of said probe structure with said tester conductors;

   the test probe system being characterized in that all conducting wires interconnecting signal probes (102) of said probe structure with signal carrying terminals of said space transformer (12) lie within said wiring plane (50) uniformly spaced apart from a ground plane (51) by a layer of insulating material (53) so as to provide a transmission line having a predetermined impedance in order to achieve an improved high frequency transmission of signals between the integrated circuit device (18) and the tester.

2. The system of claim 1, characterized by comprising a decoupling capacitor (74) associated with said power and ground planes of said space transformer, said space transformer including means (70, 72) for establishing a low inductance connection of said decoupling capacitor to said power (46) and ground planes (48).

3. The system of claim 2, characterized in that each of said probes (130) associated with said signal wiring planes includes a coaxial insulation sheath (128) coextensive with substantially the entire length of its respective probe.

4. The system of claim 3, characterized in that said rigid probe structure (14) further comprises a highly conductive interposer body (100), through which said probes extend, said interposer body being of sufficient structural strength to rigidly maintain said probes in alignment when compressively placed in contact with the pads of said integrated circuit.

5. The system of claim 4, characterized in that said ground probe (104) is in direct electrical contact with said interposer body (100) and said power probe (106) is insulated from said interposer body such as to have a characteristic impedance of less than an ohm.

6. The system of claim 5, characterized in that said power, ground and signal probes are comprised of a high gold content alloy.

7. The system of claim 6, characterized in that said power probe (106) includes an insulator sheath (134) having a thickness ranging between approximately 50 nm and 400 nm.

## Patentansprüche

1. Filtersystem für das nicht destruktive Verbinden eines Hochgeschwindigkeitstestgerätes mit der geräteeigenen Kontaktflächenanordnung einer integrierten Schaltungsvorrichtung, mit
   a) einem Mehrschichtadapter (12) mit mindestens einer Leistungsebene (46), einer Masse-Ebene (48) und einer Signalleiterebene (50);
   b) einer starren Filterstruktur (14) mit mehreren parallelen Filtern, die räumlich angeordnet sind in im wesentlichen senkrechter Übereinstimmung mit der Kontaktflächenanordnung der integrierten Schaltung (18), wobei die Filter mindestens einen Leistungs- (106), Masse- (104) und Signalfilter (102) umfassen, die jeweils ihrer entsprechenden Leistungs-, Masse- und Signalleiterebene des Adapters zugeordnet sind; und
   c) Mitteln (156) zum Aufrechterhalten des Kontaktes zwischen mehreren Leitern (154) mit Anschlüssen (62, 64, 66) des Adapters zum Anschließen desselben an das Testgerät, wobei mindestens ein entsprechender Leiter jeder Leistungs- (46), Masse- (48) und Signalleiter- (50) Ebene zugeordnet ist und der Adapters Mittel (152) zur leitenden Verbindung der Filter der Filterstruktur mit den Testgerätleitern enthält; wobei das Filtersystem dadurch gekennzeichnet ist, daß alle Leitungen, welche Signalfilter (102) der Filterstruktur mit signalführenden Anschlüssen des Adapters (12) verbinden, innerhalb der Leiterebene (50) vorgesehen sind, einheitlich beabstandet von einer Masseebene (51) durch eine Isolierschicht (53), so daß eine Übertragungsleitung mit einem bestimmten Widerstand gebildet wird, um eine verbesserte Hochfrequenzübertragung von Signalen zwischen der integrierten Schaltung (18) und dem Testgerät zu gewährleisten.

2. System nach Anspruch 1, dadurch gekennzeichnet, daß es einen den Leistungs- und Masseebenen des Adapters zugeordneten Entkopplungskondensator (74) enthält, wobei der Adapter Mittel (70, 72) zum Herstellen einer Verbindung niedriger Induktivität zwischen dem Entkopplungskondensator und den Leistungs- (46) und Masseebenen (48) aufweist.

3. System nach Anspruch 2, dadurch gekennzeichnet, daß jeder dieser den Signalleiterebenen zugeordneten Filter (130) eine koaxiale Isolierhülle (128) enthält, welche sich längs der im wesentlichen gesamten Länge des entsprechenden Filters erstreckt.

4. System nach Anspruch 3, dadurch gekennzeichnet, daß die starre Filterstruktur (14) weiterhin ein hochleitendes Zwischenstück (100) enthält, durch welches sich die Filter erstrecken, und das von ausreichender struktureller Stabilität ist, um die Filter in komprimierendem Kontakt mit den Kontaktflächen der integrierten Schaltung starr ausgerichtet zu halten.

5. System nach Anspruch 4, dadurch gekennzeichnet, daß der Massefilter (104) sich in direktem elektrischen Kontakt mit dem Zwischenstück (100) befindet und der Leistungsfilter (106) vom Zwischenstück isoliert ist, so daß er einen typischen Widerstand von weniger als 1 Ohm zeigt.

6. System nach Anspruch 5, dadurch gekennzeichnet, daß die Leistungs-, Masse- und Signalfilter aus einer Legierung mit einem hohen Goldgehalt bestehen.

7. System nach Anspruch 6, dadurch gekennzeichnet, daß der Leistungsfilter (106) eine Isolierhülle (134) mit einer Dicke zwischen ca. 50 nm und 400 nm enthält.

## Revendications

1. Système de sondes de test pour interconnecter de façon non-destructive un dispositif de test rapide au réseau de plots conducteurs bruts d'un dispositif de circuit intégré, comprenant
   a) un transformateur d'espacements multicouche (12) comportant au moins un plan d'alimentation (46), un plan de masse (48) et un plan de connexions de signaux (50);
   b) une structure de sondes rigide (14) comportant une pluralité de sondes parallèles disposées spatialement en réseau pour adapteur de façon sensiblement perpendiculaire au réseau de plots du circuit intégré (18), les sondes comportant au moins une sonde d'alimentation (106), une sonde de masse (104) et une sonde de signaux (102) associées à leurs plans d'alimentation, de masse et de connexions de signaux respectifs du transformateur d'espacements; et
   c) des moyens (156) pour maintenir une pluralité de conducteurs (154) en contact avec des bornes (62, 64, 66) du transformateur d'espacements pour interconnecter le transformateur d'espacements au dispositif de test, au moins l'un respectif des conducteurs étant associé à chacun des plans d'alimentation (46), de masse (48) et de connexions de signaux (50), le transformateur d'espacements comportant des moyens (152) pour interconnecter de façon conductrice les sondes de la structure de sondes aux conducteurs du dispositif de test;
   le système de sondes de test étant caractérisé en ce que toutes les connexions conductrices interconnectant les sondes de signaux (102) de la structure de sondes aux bornes support de signaux du transformateur d'espacements (12) sont situées à l'intérieur du plan d'interconnexions (50) séparé uniformément d'un plan de masse (51) par une couche de matériau isolant (53) de façon à fournir une ligne de transmission ayant une impédance prédéterminée pour obtenir une transmission de signaux à haute fréquence améliorée entre le dispositif de circuit intégré (18) et le dispositif de test.

2. Système selon la revendication 1, caractérisé par le fait qu'il comprend une capacité de découplage (74) associée aux plans d'alimentation et de masse du transformateur d'espacements, le transformateur d'espacements comportant des moyens (70, 72) pour établir une connexion de faible inductance entre la capacité de découplage et les plans d'alimentation (46) et de masse (48).

3. Système selon la revendication 2, caractérisé en ce que chacune des sondes (130) associées aux plans de connexions de signaux comprend une gaine coaxiale d'isolement (128) qui s'étend autour de sa sonde respective sur sensiblement la longueur entière.

4. Système selon la revendication 3, caractérisé en ce que la structure de sondes rigide (14) comprend en outre un corps (100) intercalaire fortement conducteur au travers duquel les sondes s'étendent, le corps intercalaire ayant une rigidité suffisante pour maintenir de façon rigide les sondes en alignement lorsqu'elles sont placées, selon une compression, en contact avec les plots du circuit intégré.

5. Système selon la revendication 4, caractérisé en ce que la sonde de masse (104) est en contact électrique direct avec le corps intercalaire (100), et en ce que la sonde d'alimentation (106) est isolée du corps intercalaire de façon à avoir une impédance caractéristique inférieure à un ohm.

6. Système selon la revendication 5, caractérisé en ce que les sondes d'alimentation, de masse et de signaux sont composées d'un alliage à forte teneur en or.

7. Système selon la revendication 6, caractérisé en ce que la sonde d'alimentation (106) comprend une gaine isolante (134) ayant une épaisseur comprise entre approximativement 50 nm et 400 nm.

## FIG. 1.

## FIG. 2.

# FIG. 3.

# FIG. 4.

TO
INSTRUMENTATION

TO
INSTRUMENTATION

152

152

30

152

152

154

156

154

20

14

PROBES

12

150